# EUROPEAN PATENT SPECIFICATION

(11) **EP 3 109 868 B1**
(45) Date of publication and mention of the grant of the patent: **31.01.2018**
(21) Application number: 15180676.7
(22) Date of filing: 12.08.2015
(51) Int. Cl.: H01C 1/142, H01C 7/102, H01C 17/28

(54) **PREPARATION METHOD FOR ELECTRONIC COMPONENTS WITH AN ALLOY ELECTRODE LAYER**
HERSTELLUNGSVERFAHREN FÜR ELEKTRONISCHE KOMPONENTEN MIT EINER LEGIERUNGSELEKTRODENSCHICHT
PROCÉDÉ DE PRÉPARATION DE COMPOSANTS ÉLECTRONIQUES AVEC UNE COUCHE D'ÉLECTRODE EN ALLIAGE

(30) Priority: 03.04.2015 CN 201510158484
(43) Date of publication of application: 28.12.2016
(73) Proprietor: Thinking Electronic Industrial Co., Ltd., Kaohsiung City (TW)
(72) Inventor: XU, Xun, Kaohsiung City (TW); JIA, Zhiwei, Kaohsiung City (TW)
(74) Representative: Robba, Pierpaolo

(56) References cited:
- CN-A- 102 324 290
- GB-A- 979 638
- JP-A- 2014 224 302
- US-A- 4 431 983
- US-A- 4 538 347

## Description

### Field of the Invention

The present invention relates to a preparation method for an electronic component and, more particularly, to a preparation method for an electronic component with an alloy electrode layer.

### Description of the Related Art

Varistor is a delicate electronic ceramic component that is fabricated from a mixture of a base material, which includes electronic grade zinc oxide (ZnO) powder, and various small amount of additives, such as electronic grade bismuth oxide (Bi₂O₃), cobalt oxide (Co₂O₃), manganese dioxide (MnO₂), antimony trioxide (Sb₂O₃), titanium dioxide (TiO₂), chromium oxide (Cr₂O₃), nickel oxide (Ni₂O₃) and the like added thereto, through mixing, molding and sintering processes, making that the varistor is naturally sensitive to variation of externally applied voltage and it is thus applicable for the varistor to sense and limit all transient overvoltage occurring in circuit and absorb the resulting surge energy.

To lower the fabrication cost of varistor, China patent application number 201110140236.1, entitled "Copper-electrode zinc-oxide voltage sensitive resistor and preparation method thereof", discloses a conventional technique of doping and sintering base metal using a chain-belt type tunnel furnace under an oxygen-free atmosphere environment. However, the copper electrode of the varistor fabricated by the conventional technique is prone to oxidation under high-temperature operation, which becomes a durability issue for electronic appliances at home or in industrial area. Additionally, as such conventional technique also needs to consume lots of inert gas, despite the cost down effect arising from the base metal, the varistor produced by the conventional technique is not so cost-effective because of the rising auxiliary production costs. Due to the tendency of oxygen absorption, acceptance rate of mass-produced varistors cannot be guaranteed.

US4,538,347 discloses a process for making an encapsulated metal oxide varistor package which includes pressing the varistor powder mixture into a disc, sintering the pressed disc, followed by slow cooling to room temperature. The sintered disc is acid etched and a fritted-silver electrode applied on each side of the disc or in the alternative an aluminum coating is arc sprayed on each side of the disk followed by an arc sprayed copper coating on top of the aluminum coating. The fritted-silver electrode coating is heated to 660 °C and slow cooled to room temperature. Sn-coated copper leads are soldered on the electroded disc of either electrode process and the assembly is encapsulated in resilient epoxy resin to form the encapsulated metal oxide varistor package.

In JP2014224302 a problem to be solved targets at providing a base metal composite electrode of an electronic ceramic element, and a manufacturing method thereof, and a solution to that problem is a base metal composite electrode, which includes a first base metal electrode layer and a second base metal electrode layer. The first base metal electrode layer covers both faces of an electronic ceramic chip, and the second base metal electrode layer covers the first base metal electrode layer. The method for manufacturing a base metal composite electrode of the electronic ceramic element includes a step of spray-coating a surface of the electronic ceramic chip with an electrode material using a flame spray device. The base metal electrode material includes aluminum and copper, aluminum and zinc, aluminum and nickel, or aluminum and tin.

An objective of the present invention is to provide a preparation method for an electronic component with an alloy electrode layer targeting at enhancing the reliability of base metal copper electrode under a high-temperature environment upon solving the cost issue of an electronic component with the electrode.

To achieve the foregoing objective, the present invention provides a preparation method for an electronic component with an alloy electrode layer according to claim 1, said method includes steps of:
preparing a ceramic substrate having two opposite surfaces;
printing a metal layer on each of the two opposite surfaces of the ceramic substrate, wherein the material of the metal layer is aluminum;
spraying an alloy layer on an outer surface of each metal layer, wherein the alloy layer is a copper alloy layer, and each metal layer and a corresponding alloy layer stacked on the metal layer form an electrode layer;
connecting a pin to each alloy layer; and
enclosing the ceramic substrate, the electrode layers and a portion of each pin with an insulating layer.

According to the foregoing description of the preparation method, the metal layers and the alloy layers are integrated to form a multilayer structure, which is taken as an electrode layer of the electronic component. In contrast to conventional electrode structure with copper layer only, the present invention employs a copper alloy layer for the electrode layer to keep competitive advantages of being low in production cost and also enhancing reliability of the electronic component at the same time. Given a varistor as an example of the electronic component, the varistor fabricated by the preparation method has a lower varistor voltage variation after the varistor becomes aged and increases the capacity of resisting more combination waves before failure of the varistor.

Other objectives, advantages and novel features of the invention will become more apparent from the following detailed description when taken in conjunction with the accompanying drawings.

### Brief description of the drawings

Fig. 1A is a front view in partial section of an electronic component in accordance with the present invention;
Fig. 1B is a side view in partial section of the electronic component in Fig. 1A;
Fig. 2 is a flow chart showing a fabrication process of an electronic component;
Fig. 3 is a schematic diagram showing electric arc spray; and
Fig. 4 is a flow diagram of a preparation method in accordance with the present invention.

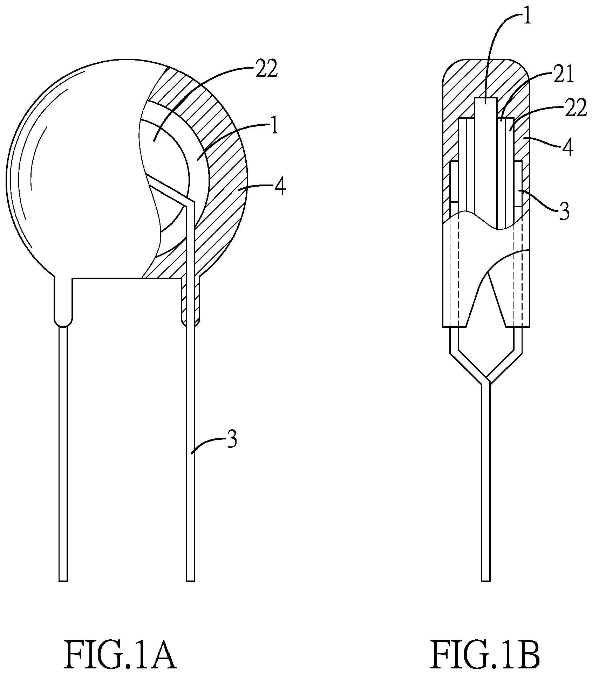

With reference to Figs. 1A and 1B, an electronic component in accordance with the present invention includes a ceramic substrate 1, two metal layers 21, two alloy layers 22, two pins 3 and an insulating layer 4.

The two metal layers 21 are respectively formed on two opposite surfaces of the ceramic substrate 1. Each alloy layer 22 is stacked on an outer surface of one of the two metal layers 21, and the multi-layer structure of the metal layers 21 and the alloy layers 22 are taken as an electrode layer of the electronic component. The two pins 3 are electrically connected to the respective alloy layers 22. The insulating layer 4 encloses the ceramic substrate 1, the metal layers 21, the alloy layers 22 and one end of each pin 3 connected to a corresponding alloy layer 22.

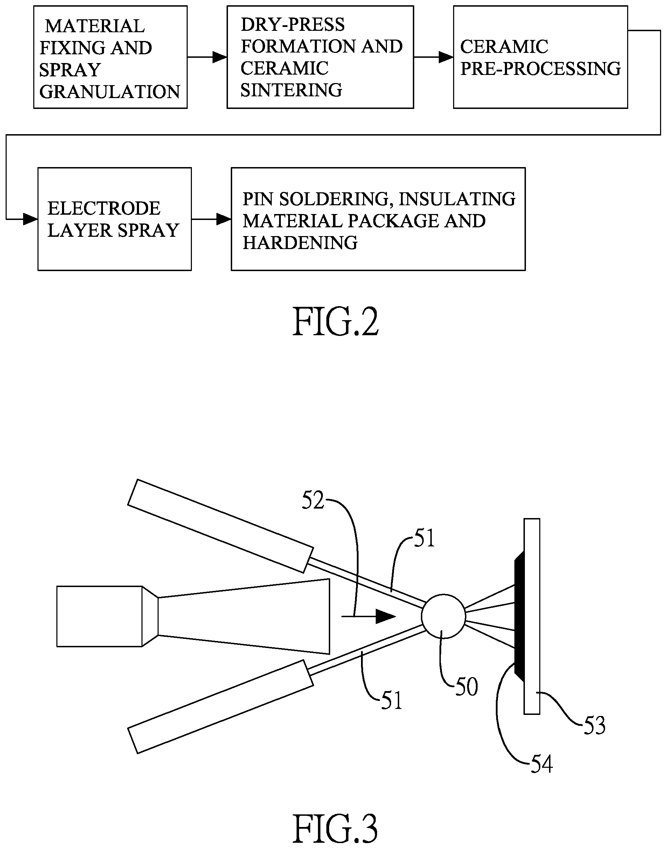

With reference to Fig. 2, a fabrication process of an electronic component is shown. Given varistor as an example of the electronic component, steps of fixing materials, spray granulation, dry-press formation and ceramic sintering that pertain to steps for producing the ceramic substrate 1 are not repeated here. After the ceramic substrate 1 is completed, steps of silk-screen print of the ceramic substrate, electric arc spray of the electrode layer, soldering of the pins, insulating material package and hardening, associated with the present invention can then begin.

To depict the fabrication process of a first embodiment of the electronic component in accordance with the present invention, varistor 14471 is chosen to elaborate the following embodiment of the electronic component whose diameter and thickness are 14 mm and 1.8 mm respectively.

### First Embodiment

Steps of producing the metal layers 21:
1. Clean surfaces of the ceramic substrate 1.
2. Blend glass powder and a binder with pure aluminum powder to acquire an aluminum slurry with a weight percent of aluminum in a range of 65∼75%. The glass powder includes silicon dioxide (SiO2), bismuth oxide (BiO2) and boron trioxide (B2O3) and has a weight percent in a range of 10% ∼ 15%. The binder has a weight percent in a range of 10% ∼ 25% and the contents of the binder include ethylcellulose and terpineol. The aluminum slurry can be coated on a first surface of the ceramic substrate 1 through silk-screen printing.
3. Place the ceramic substrate 1 printed with the aluminum slurry into an oven for baking for 60 minutes at 100 °C, remove the ceramic substrate 1 done with the baking, coat the aluminum slurry on a second surface opposite to the first surface through the same silk-screen printing, and place the ceramic substrate 1 back into the oven and bake for 60 minutes at 100°C.
4. Place the ceramic substrate 1 with the first surface and the second surface done with the printing into a tunnel furnace in a temperature range 600 °C∼750 °C for sintering in completion of the fabrication of the metal layer 21.

Steps of producing the alloy layers 22:
Fasten the ceramic substrate 1 with the sintered metal layer 21 on a thermal spray fixture.

With reference to Fig. 3, concepts of electric arc spray are well-known and are thus merely briefly introduced here. The electric arc spray is performed by applying electric arc to melt a pair of electrically conductive wires 51 and using high-speed air flow 52 to atomize the melting pair of electrically conductive wires 51 into small metal particles. The metal particles are propelled by the high speed air flow 52 toward a work piece 53 to form a spray layer 54 on a surface of the work piece 53. In the present embodiment, the pair of electrically conductive wires is a pair of aluminum bronze wires, and spray parameters associated with the electric arc spray include spray voltage in a range of 20 ∼ 35 V, spray current in a range of 100 ∼ 200 A, spray pressure in a range of 0.5 ∼ 0.6 MPa, wire-feeding voltage in a range of 10 ∼ 14 V, and spray thickness in a range of 20 ∼ 30 *µ*m. Fabrication of the alloy layer 22 is completed by the electric arc spray. In the present embodiment, the alloy layer 22 of the electrode layer is formed by an alloy made from aluminum and copper.

The two pins 3 are respectively welded on the alloy layers 22 and then epoxy is used to wrap up the ceramic substrate 1, the metal layer 21, the alloy layer 22 and a portion of the pins 3 to form the insulating layer 4. Electrical characteristics of the finished electronic component are further tested.

As shown in the following table, the pair of electrically conductive wires from the second embodiment to the fifth embodiment on the basis of the first embodiment can be a pair of wires made from different alloys, namely, silicon bronze, phosphor bronze, tin bronze, tin phosphor bronze, with different percents of metal contents. Detailed spraying steps already introduced are not repeated here.

Given as an example, an aging test is performed to compare aging characteristics against high-temperature environment among all the embodiments. Test conditions for the high-temperature aging test are 125 ± 2 °C, 1000 ± 24 hours and applied voltage VDC = 385 V. Varistor voltages before and after the aging test, variation of the varistor voltage, and capacity (times) of combination wave (6 kV/3 kA) resistance are shown in the following table.

| Electronic component | Contents of spray material | Aging test | | | |
|---|---|---|---|---|---|
| | | Varistor voltage before test (V1mA) | Varistor voltage after test (V1mA) | Voltage variation (%) | Combination wave (6kV*3kA) (times) |
| Conventional 1 | Conventional printing + silver spray | 453 | 432 | 4.60% | 62 |
| Conventional 2 | Silk-screen printing with aluminum + purple bronze spray (99.90% copper) | 476 | 441 | 7.40% | 109 |
| First embodiment | Silk-screen printing with aluminum + aluminum bronze spray (7.5% aluminum + remaining % copper) | 468 | 453 | 3.20% | 106 |
| | Silk-screen printing with aluminum + aluminum bronze spray (7.9% aluminum + remaining % copper) | 458 | 449 | 2.00% | 103 |
| | Silk-screen printing with aluminum + aluminum bronze spray (8.4% aluminum + remaining % copper) | 466 | 458 | 1.70% | 107 |
| Second embodiment | Silk-screen printing with aluminum + silicon bronze spray (2.8% silicon + remaining % copper) | 485 | 469 | 3.30% | 112 |
| | Silk-screen printing with aluminum + silicon bronze spray (3.2% silicon + remaining % copper) | 474 | 463 | 2.30% | 109 |
| | Silk-screen printing with aluminum + silicon bronze spray (4.0% silicon + remaining % copper) | 462 | 457 | 1.10% | 112 |
| Third embodiment | Silk-screen printing with aluminum + phosphor bronze spray (7.5% phosphor + remaining % copper) | 442 | 436 | 1.40% | 98 |
| | Silk-screen printing with aluminum + phosphor bronze spray (8.1% phosphor + remaining % copper) | 446 | 439 | 1.60% | 104 |
| | Silk-screen printing with aluminum + phosphor bronze spray (8.5% phosphor + remaining % copper) | 442 | 432 | 2.30% | 111 |
| Fourth embodiment | Silk-screen printing with aluminum + tin bronze spray (4% tin + remaining % copper) | 490 | 475 | 3.10% | 110 |
| | Silk-screen printing with aluminum + tin bronze spray (5% tin + remaining % copper) | 480 | 468 | 2.50% | 100 |
| | Silk-screen printing with aluminum + tin bronze spray (6% tin + remaining % copper) | 484 | 475 | 1.90% | 101 |
| Fifth embodiment | Silk-screen printing with aluminum + tin phosphor bronze spray (phosphor 7.1%, 5.8% tin + remaining % copper) | 471 | 460 | 2.30% | 113 |

As can be seen from the foregoing table, the electronic components with the multi-layer electrode structure produced by printing with aluminum and spraying with copper alloys wires have lower voltage variation after the aging test than the electronic component with the conventional silver printed electrode, and the voltage variation of all the embodiments is lower than 4%. The capacity (times) of combination wave resistance of the electronic components relative to that of the electronic component with the conventional silver printed electrode is increased by 40%.

The shape of the multi-layer electrode in accordance with the present invention includes, but is not limited to, square-shaped, round, oval, tubular, cylindrical and conic. The types of the electronic components in accordance with the present invention may be voltage-sensitive components, gas-sensitive components, positive temperature coefficient (PTC) thermally sensitive components, negative temperature coefficient (NTC) thermally sensitive components, piezoelectric ceramic, ceramic capacitors and the like.

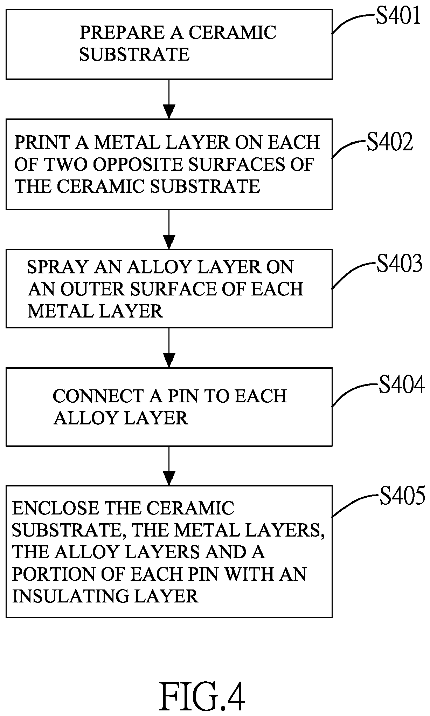

With reference to Fig. 4, a preparation method for an electronic component with an alloy electrode layer in accordance with the present invention includes steps of:
Step S401: Prepare a ceramic substrate 1 having two opposite surfaces.
Step S402: Print a metal layer 21 on each of the two opposite surfaces of the ceramic substrate 1. The material of the metal layer 21 is aluminum.
Step S403: Spray an alloy layer 22 on an outer surface of each metal layer 21. The alloy layer 22 is a copper alloy layer. Each metal layer 21 and a corresponding alloy layer 22 stacked on the metal layer 21 form an electrode layer.
Step S404: Connect a pin 3 to each alloy layer 22.
Step S405: Enclose the ceramic substrate 1, the electrode layers and a portion of each pin 3 with an insulating layer 4.

Even though numerous characteristics and advantages of the present invention have been set forth in the foregoing description, together with details of the structure and function of the invention, the disclosure is illustrative only. Changes may be made in detail, especially in matters of shape, size, and arrangement of parts within the principles of the invention to the full extent indicated by the broad general meaning of the terms in which the appended claims are expressed.

## Claims

1. A preparation method for an electronic component with an alloy electrode layer, comprising steps of:
preparing a ceramic substrate (1) having two opposite surfaces;
printing a metal layer (21) on each of the two opposite surfaces of the ceramic substrate (1), wherein the material of the metal layer (21) is aluminum;
spraying an alloy layer (22) on an outer surface of each metal layer (21), wherein the alloy layer (22) is a copper alloy layer (22), and each metal layer (21) and a corresponding alloy layer (22) stacked on the metal layer (21) form an electrode layer;
connecting a pin (3) to each alloy layer (22); and
enclosing the ceramic substrate (1), the electrode layers and a portion of each pin (3) with an insulating layer (4);
**characterized in that** the metal layer (21) is formed by sintering a baked aluminum slurry.

2. The preparation method as claimed in claim 1, wherein the aluminum slurry includes aluminum powder,
glass powder and a binder, and a weight percent of the aluminum powder in the aluminum slurry is in a range of 65 to 75%, a weight percent of the glass powder in the aluminum
slurry is in a range of 10% to 15%, and a weight percent of the binder is in a range 10% to 25%.

3. The preparation method as claimed in claim 1, wherein in the step of spraying the alloy layer (22), the alloy layer (22) is made from an aluminum bronze alloy having a weight percent of aluminum in a range of 7.5% to 8.4% and a remaining weight percent of copper.

4. The preparation method as claimed in claim 1, wherein in the step of spraying the alloy layer (22), the alloy layer (22) is made from a silicon bronze alloy having a weight percent of silicon in a range of 2.8% to 4.0% and a remaining weight percent of copper.

5. The preparation method as claimed in claim 1, wherein in the step of spraying the alloy layer (22), the alloy layer (22) is made from a phosphor bronze alloy having a weight percent of phosphor in a range of 7.5% to 8.5% and a remaining weight percent of copper.

6. The preparation method as claimed in claim 1, wherein in the step of spraying the alloy layer (22), the alloy layer (22) is made from a tin bronze alloy having a weight percent of tin in a range of 4% to 6% and a remaining weight percent of copper.

## Patentansprüche

1. Herstellungsverfahren für elektronische Komponenten mit einer Legierungselektrodenschicht, umfassend die folgenden Schritte:
Herstellen eines keramischen Substrats (1) mit zwei gegenüberliegenden Oberflächen;
Drucken einer Metallschicht (21) auf jede der beiden gegenüberliegenden Oberflächen des keramischen Substrats (1), wobei es sich bei dem Material der Metallschicht (21) um Aluminium handelt;
Aufspritzen einer Legierungsschicht (22) auf eine Außenfläche jeder Metallschicht (21), wobei es sich bei der Legierungsschicht (22) um eine Kupferlegierungsschicht (22) handelt, und wobei jede Metallschicht (21) und eine entsprechende auf der Metallschicht (21) aufgestapelte Legierungsschicht (22) eine Elektrodenschicht bilden;
Verbinden eines Stiftes (3) mit jeder Legierungsschicht (22); und
Umhüllen des keramischen Substrats (1), der Elektrodenschichten und eines Abschnitts jedes Stiftes (3) mit einer Isolierungsschicht (4);
**dadurch gekennzeichnet, dass** die Metallschicht (21) durch Sintern einer eingebrannten Aluminiumaufschlämmung gebildet wird.

2. Herstellungsverfahren nach Anspruch 1, wobei die Aluminiumaufschlämmung Aluminiumpulver, Glaspulver und ein Bindemittel umfasst, und wobei ein Gewichtsprozent Aluminiumpulver in der Aluminiumaufschlämmung in einem Bereich von 65% bis 75% liegt, ein Gewichtsprozent Glaspulver in der Aluminiumaufschlämmung in einem Bereich von 10% bis 15% liegt, und ein Gewichtsprozent Bindemittel in einem Bereich von 10% bis 25% liegt.

3. Herstellungsverfahren nach Anspruch 1, wobei bei dem Schritt des Aufspritzens der Legierungsschicht (22) die Legierungsschicht (22) aus einer Aluminium-Bronze-Legierung besteht, die ein Gewichtsprozent Aluminium in einem Bereich von 7,5% bis 8,4% und ein restliches Gewichtsprozent Kupfer enthält.

4. Herstellungsverfahren nach Anspruch 1, wobei bei dem Schritt des Aufspritzens der Legierungsschicht (22) die Legierungsschicht (22) aus einer Silizium-Bronze-Legierung besteht, die ein Gewichtsprozent Silizium in einem Bereich von 2,8% bis 4,0% und ein restliches Gewichtsprozent Kupfer enthält.

5. Herstellungsverfahren nach Anspruch 1, wobei bei dem Schritt des Aufspritzens der Legierungsschicht (22) die Legierungsschicht (22) aus einer Phosphor-Bronze-Legierung besteht, die ein Gewichtsprozent Phosphor in einem Bereich von 7,5% bis 8,5% und ein restliches Gewichtsprozent Kupfer enthält.

6. Herstellungsverfahren nach Anspruch 1, wobei bei dem Schritt des Aufspritzens der Legierungsschicht (22) die Legierungsschicht (22) aus einer Zinn-Bronze-Legierung besteht, die ein Gewichtsprozent Zinn in einem Bereich von 4% bis 6% und ein restliches Gewichtsprozent Kupfer enthält.

## Revendications

1. Procédé de préparation d'un composant électronique ayant une couche d'électrode en alliage, ce procédé comprenant les étapes de:
- préparer un substrat céramique (1) ayant deux surfaces opposées;
- imprimer une couche métallique (21) sur chacune des deux surfaces opposées du substrat céramique (1), le matériau de la couche métallique (21) étant aluminium;
- pulvériser une couche en alliage (22) sur une surface extérieure de chaque couche métallique (21), la couche en alliage (22) étant une couche en alliage de cuivre (22), et chaque couche métallique (21) et une couche en alliage (22) correspondante empilée sur la couche métallique (21) formant une couche d'électrode;
- connecter une broche (3) sur chaque couche en alliage (22); et
- envelopper le substrat céramique (1), les couches d'électrode et une portion de chaque broche (3) dans une couche isolante (4);
**caractérisé en ce que** la couche métallique (21) est formée par frittage d'une suspension d'aluminium cuite.

2. Procédé de préparation selon la revendication 1, dans lequel la suspension d'aluminium comprend poudre d'aluminium, poudre de verre et un liant, et un pourcentage en poids de la poudre d'aluminium dans la suspension d'aluminium est compris entre 65% et 75%, un pourcentage en poids de la poudre de verre dans la suspension d'aluminium est compris entre 10% et 15%, et un pourcentage en poids du liant est compris entre 10% et 25%.

3. Procédé de préparation selon la revendication 1, dans lequel, dans l'étape de pulvérisation de la couche en alliage (22), la couche en alliage (22) est formée par un alliage de bronze à l'aluminium, avec un pourcentage en poids d'aluminium compris entre 7,5% et 8,4%, et un restant pourcentage en poids de cuivre.

4. Procédé de préparation selon la revendication 1, dans lequel, dans l'étape de pulvérisation de la couche en alliage (22), la couche en alliage (22) est formée par un alliage de bronze au silicium, avec un pourcentage en poids de silicium compris entre 2,8% et 4,0%, et un restant pourcentage en poids de cuivre.

5. Procédé de préparation selon la revendication 1, dans lequel, dans l'étape de pulvérisation de la couche en alliage (22), la couche en alliage (22) est formée par un alliage de bronze au phosphore, avec un pourcentage en poids de phosphore compris entre 7,5% et 8,5%, et un restant pourcentage en poids de cuivre.

6. Procédé de préparation selon la revendication 1, dans lequel, dans l'étape de pulvérisation de la couche en alliage (22), la couche en alliage (22) est formée par un alliage de bronze à l'étain, avec un pourcentage en poids d'étain compris entre 4% et 6%, et un restant pourcentage en poids de cuivre.
